(19) Europäisches Patentamt
European Patent Office
Office européen des brevets

(11) **EP 3 142 201 A1**

(12) **EUROPEAN PATENT APPLICATION**

(43) Date of publication:
**15.03.2017 Bulletin 2017/11**

(51) Int Cl.:
*H01S 5/024* (2006.01)        *H01S 5/06* (2006.01)
*G01N 21/3504* (2014.01)        *G01N 21/39* (2006.01)

(21) Application number: **15184939.5**

(22) Date of filing: **11.09.2015**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**MA**

(71) Applicant: **Michell Instruments Ltd.
Ely, Cambridgeshire CB6 3NW (GB)**

(72) Inventors:
• **STOKES, Andrew M. V.
  Bottisham, Cambridgeshire CB25 9TA (GB)**
• **SUMMERS, Michael
  Ely, Cambridgeshire CB7 4BA (GB)**
• **PAGE, Hideaki
  Cottenham, Cambridgeshire CB24 8TG (GB)**

(74) Representative: **Gill Jennings & Every LLP
The Broadgate Tower
20 Primrose Street
London EC2A 2ES (GB)**

(54) **A TUNING SYSTEM FOR A TUNEABLE DIODE LASER SPECTROSCOPY DEVICE COMPRISING A TERMO ELECTRIC COOLER AND A FURTHER COOLER**

(57)    A laser thermal tuning system for a tuneable diode laser spectroscopy device. The system comprises a laser diode 2 arranged between and coupled to each of a thermoelectric cooler 3 and a Stirling cooler 4; and control means for controlling each of the thermoelectric cooler 3 and the Stirling cooler 4 to control the temperature of the laser diode 2 and thereby vary the output wavelength of the laser diode 2. The system may comprise a thermal mount 5 which may be arranged to provide an interface from the laser diode 2 to the Stirling cooler 4. The thermal mount may be arranged to provide an interface from the laser diode 2 to the external environment via the thermoelectric cooler 3. This interface may be further enhanced by the addition of a heat sink 6.

FIG. 2a

## Description

The present invention relates to laser spectroscopy, and more particularly, to a Laser Thermal Tuning System (LTTS) and a resulting multi-species spectroscopic analyser comprising the LTTS, wherein the output wavelength of the LTTS may be accurately controlled and the range of accessible wavelengths increased for the tuneable element of the LTTS.

Laser spectroscopy is a well-known and established measurement technique which uses the fundamental absorption of light by gases and liquids which is known to occur at characteristic wavelengths in order to accurately determine the concentration of the various components present in said gas or liquid mixture.

There are many well-known spectroscopy techniques. Examples include direct absorption spectroscopy (DAS), wavelength modulated spectroscopy (WMS), frequency modulated spectroscopy (FMS), cavity enhanced absorption spectroscopy (CEAS), and photo acoustic spectroscopy (PAS), amongst others. Most are generically referred to as tuneable diode laser absorption spectroscopy (TDLAS) techniques.

A fundamental limitation of such TDLAS techniques is that the lasers, from whatever laser technology they are sourced, are manufactured to produce light of a specific wavelength and therefore only work over a limited spectral range. Accordingly, spectroscopic detection systems may be broadly divided into two categories: broadband, low resolution systems; and narrow band, high resolution systems.

The following examples are given to illustrate the problem: Fourier Transform Infrared Spectrometry (FTIR) employs a black body source to generate a wide spectrum of wavelengths covering the infrared portion of the electromagnetic spectrum. This allows many absorption bands of different molecules to be detected. However, high resolution measurements with an FTIR are challenging, and fine spectral detail is lost. Conversely, TDLAS has an intrinsic high resolution in the region of several MHz due to the narrow line width of the laser. This allows finer details of the molecular spectra to be resolved but only over a narrow wavelength tuning range that, depending on the specific current tuning characteristic of the laser used, can be approximately 1 nm in the near-infrared. Therefore, although the technique is inherently capable of discriminating the detail needed, the limited spectral range of the lasers used in TDLAS can be seen to be a primary limiting factor preventing such an analyser from being able to detect more than one or perhaps two species of interest for any given laser device. TDLAS analysers are therefore usually applied to single molecular species detection.

Furthermore, real samples to be analysed are complex, typically containing several molecular species that have overlapping spectral features and therefore detection and discrimination of, and between, these compositional elements of the sample is convoluted. In summary, the resolution of the FTIR may not be sufficient to separate the interlaced spectral features whereas the narrow tuning range of TDLAS may be insufficient to capture all of the necessary spectroscopic detail over a suitably wide spectral range.

It follows that under the prior art, a TDLAS-based analyser which can detect multiple species therefore usually requires multiple lasers and thus is expensive. However, it is clear that many laboratory and industrial processes require determination of several species simultaneously, so it follows that these applications would benefit from a system that can provide multi-species detection without the use of multiple lasers.

Laser diodes in TDLAS are typically tuned by varying their temperature, either by self-heating by controlling the driving current through the device or by varying the local environmental temperature of the laser. Usually, both methods are used in combination. The local temperature of the laser may be set to centre the tuning window on the spectroscopic region of interest and the current-induced self-heating is then used to provide a rapid tuning sweep. Varying the local temperature over a wider range will increase the tuning window of the laser. Typically, the operating temperature is set to range between 20°C either side of room temperature, extending the tuning range to several nm. It should be noted that in the prior art, increasing the operating temperature significantly above ambient room temperature is not an ideal approach for increasing the tuning range as this leads to a significant decrease in device efficiency.

In some applications of the prior art, lasers have been super-cooled in order to provide significant shifts in their working wavelengths. However, such super-cooling usually requires cryogenic techniques which are expensive, and whilst this may be acceptable in a controlled laboratory environment, it is usually an unacceptable, or unsuitable, technique for continuous operation or for industrial applications where there is an expectation that an analyser will be able to work for periods of many years with minimal user intervention.

Attempts have been made to use cooling techniques in order to increase the spectral range of laser diodes. For example, it has been suggested to use cascaded cooling elements or heat pumps to enhance the efficiency of the system and hence attain low temperatures. However, one problem with using cascaded thermoelectric coolers alone is that the efficiency of thermoelectric coolers is well known to diminish in direct relationship to their operating temperature. This is a particularly limiting factor at temperatures approaching cryogenic levels because if it is to be used to control the laser temperature the thermoelectric cooler must cool against both the ambient heat load as well as the self-heating of the laser. It will be clear to anyone versed in the art that the lower the temperature of the system that is required, the less cooling power there is available to overcome the self-heating of the laser.

Stirling coolers may also be cascaded with thermoelectric coolers to achieve low temperatures. However, a problem with this approach is that fine control of the temperature of the Stirling cooler is difficult to achieve as these are mechanical devices with moving parts. TDLAS typically requires precise temperature control down to as much as a thousandth of a degree Celsius. The Stirling cooler is excellent for rapid cooling, but not as good when used for control. The use of a thermoelectric cooler, or other means, cascaded with the Stirling cooler can rectify this deficiency to a certain extent. However, as the thermoelectric cooler efficiency is diminished at low temperatures, the necessary level of precise temperature stability is hard to achieve. Additional heat loading due to the power dissipation in the laser diode package further exacerbates this problem.

Accordingly, there is a need for a low cost TDLAS analyser which has a wide tuning range and which is therefore able to analyse the potentially large number of species that may be present in a sample, or process, without the provision of multiple lasers or a costly and unreliable cooling system, and whilst maintaining a high resolution.

According to the present invention, there is provided a laser thermal tuning system for a tuneable diode laser spectroscopy device, the system comprising: a thermoelectric cooler; a further cooler method via open loop or closed loop; a laser diode arranged between the thermoelectric cooler and the further cooler and coupled to each of the thermoelectric cooler and the further cooler; and control means for controlling each of the thermoelectric cooler and the further cooler to control the temperature of the laser diode and thereby vary the output wavelength of the laser diode.

With the configuration of the present invention in combination with any suitable spectroscopic technique including, but not limited to, those listed in the preceding sections, it is clearly possible to provide a TDLAS analyser with an analytical wavelength range which is sufficient to analyse a large number of species yet which is low cost and has a long operating life. This may be done at much lower cost than the prior art configurations, given that there is no need to provide cryogenic cooling.

The open loop control or closed loop further cooler may be a Stirling cooler.

The present invention optimises the accuracy of control of the temperature of the device to be cooled, in particular, at low temperatures where the self-heating of the device makes it difficult to control temperatures accurately. An advantage of the arrangement of the present invention is that broad spectroscopic tuning may be achieved by allowing temperature control from cryogenic to ambient temperatures. Another advantage is that fine control of the temperature may be achieved through optimal operation of the thermoelectric cooler.

Preferably, the LTTS may further comprise a thermal mount. The thermal mount may be arranged to provide an interface from the laser diode to the further cooler. Further, the thermal mount is arranged to provide an interface from the laser diode to the external environment via the thermoelectric cooler. This interface may be further enhanced by the addition of a suitable heat transfer means, such as a heat sink.

In one example, the control means may further control the output of the laser diode to scan over a continuous range of wavelength. In another example, the control means may further control the output of the laser diode to provide scanning at discrete wavelength steps. In yet another example, separate control means may be utilised to provide the functions of controlling the output of the laser diode to scan over a continuous range of wavelengths and/or controlling the output of the laser diode to provide scanning at discrete wavelength steps.

According to the present invention, there is also provided a spectroscopic analyser comprising a laser thermal tuning system according to any preceding claim, and further comprising: an analytical measurement chamber for receiving, in use, a sample to be analysed; and a light receiving component for receiving light from the system that has passed though the sample chamber to determine the nature of the sample.

The analyser of the present invention may be configured to analyse any multi-species composition of interest, examples of which include (but are not limited to): Natural gas; Combustion gases and by-products of combustion processes; Environmental gases including, but not limited to, typical greenhouse gases; Other gases, gas mixtures or liquids where the ability to determine multi-species data would be advantageous. For illustration, in the case of natural gases, the present invention provides advantages over existing analysers in terms of its capability to analyse all or most of the constituent species present in the gas or liquid as well as providing reduced drift and other associated reliability improvements.

According to the present invention, it is also possible to provide a spectroscopic analyser comprising multiple laser thermal tuning systems and multiple control means, one associated with each laser thermal tuning system, such that the resulting increased analytical spectrum that can be provided by the analyser, enables the detection of even more species.

Certain preferred embodiments of the present invention will now be described by way of example only with reference to the accompanying drawings, in which:

Figure 1 is a schematic diagram showing a prior art analyser;

Figures 2a and 2b are a schematic diagrams showing a Laser Thermal Tuning System (LTTS) according to the present invention; and

Figure 3 is a schematic diagram showing an analyser according to the present invention.

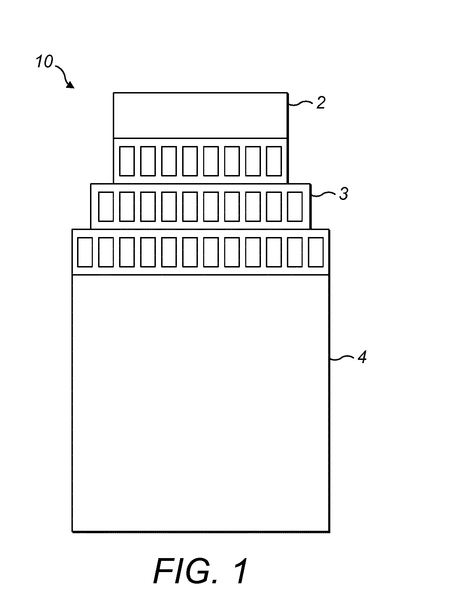

Referring to Figure 1, a system 10 for use in a spectroscopic analyser according to the prior art is shown having a laser diode 2 which is mounted on a thermoelectric cooler 3. This thermoelectric cooler is in turn mounted on a further cooler 4, which in this example may be a Stirling cooler.

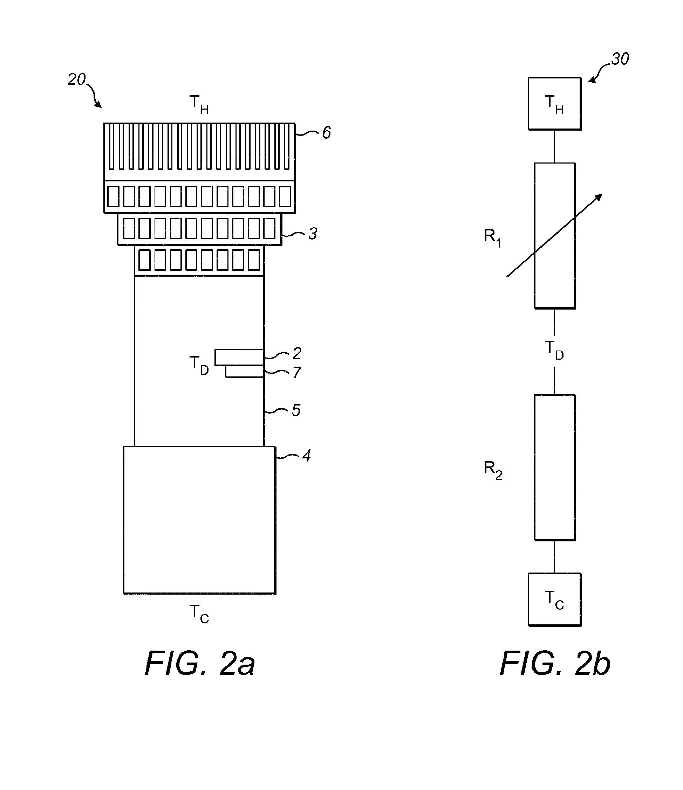

A schematic diagram of the system of the present invention is shown in Figures 2a and 2b, wherein the laser thermal tuning system 20 is analogous to a thermal potential divider 30. Referring to Figure 2B, a thermal analogy 30 of an electrical potential divider circuit is shown. A thermal potential is applied across two resistances, R1 and R2. The potential difference is equivalent to the difference in temperature between $T_H$ and $T_C$. The thermal potential at the junction between the two resistances, $T_D$, is controlled by varying the values of the two thermal resistances according to the following equation:

$$T_D = (T_H - T_C)\frac{R1}{R1 + R2}$$

wherein $T_D$ is the temperature of the device, $T_H$ is the external temperature of the ambient air, $T_C$ is the temperature of the cold head of the Stirling cooler, R1 is the thermal resistance of the upper arm of the thermal potential divider and R2 is the thermal resistance of the lower arm of the thermal potential divider.

R1 may be a variable thermal resistance that allows the laser diode temperature, $T_D$ to be controlled accurately using a thermoelectric cooler 3. Referring to Figure 2A, the thermal potential divider may be formed from a thermal mount 5 designed to sit on top of the cold head of the Stirling cooler 4 and the laser diode 2 is positioned therein. The geometry of the thermal mount 5 is chosen to allow functional access to the laser diode 2 such as optical and/or electrical access ports. Two critical interfaces exist adjacent the thermal mount 5: the joining of the thermal mount 5 to the cold head of the Stirling cooler 4, and the joining of the thermal mount 5 to the external environment via the thermoelectric cooler 3. This interface may additionally benefit from the inclusion of a suitable heat transfer component, such as a heat sink 6.

The direction of current flow in the thermoelectric cooler 3 allows heat flow from the external environment to the Stirling cooler 4. The laser diode 2 is placed strategically between these two interfaces. Heat flow through these two interfaces is controlled by the action of the Stirling cooler 4, the thermoelectric cooler 3 and the properties and geometry of the materials between the two interfaces.

The Stirling cooler 4 provides a thermal ground for the system and is typically operated to achieve the minimum desired temperature. This eliminates the need to provide problematic fine thermal control of the Stirling cooler 4. Fine temperature control is provided by controlling the heat flow into the thermal mount from the external environment via the thermoelectric cooler 3. In this configuration the thermoelectric cooler 3 may operate in heat sourcing mode rather than the less efficient heat sinking mode. Fine control of the laser diode 2 temperature, $T_D$, can be achieved by monitoring the temperature sensor 7 that is placed in close proximity to the laser diode 2 and by applying feedback control by whatever means is appropriate and will be well known to anyone versed in the art.

When the thermoelectric cooler 3 is switched off, or the control to the device is modulated or reduced by other means, there is a corresponding reduction in the efficiency of the thermal contact to the external environment which is at temperature $T_H$. Accordingly the device temperature $T_D$ will fall towards the minimum temperature, $T_C$. Heat flows into the Stirling cooler 4 from the external environment as current is applied to the thermoelectric cooler 3. The action of the thermal potential divider 30 means that the laser diode temperature increases or decreases accordingly.

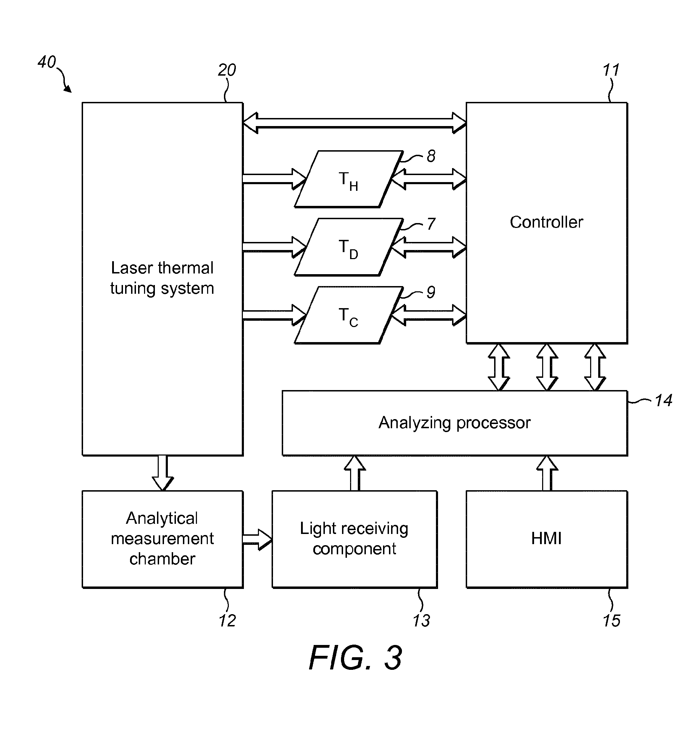

Referring now to Figure 3, an analyser 40 according to the present invention has the laser thermal tuning system 20 of Figure 2 mounted therein and connected to a controller 11. A suitable analytical measurement chamber 12 is provided adjacent to the light source and a light receiving component 13 is then positioned adjacent to the analytical measurement chamber 12. An analysing processor 14 is connected to both to the detecting component 13, the controller 11, and where advantageous a suitable human-machine interface 15. In use the analyser 10 of the present invention may be connected to a larger industrial system, such as a natural gas processor, the output of a combustion system, or an environmental gas detection system in a manner which is well known in the art, this would also apply to the present invention. Suitable temperature measurement devices 7, 8, and 9 monitor temperature for the thermal mount ($T_D$) - and therefore also the laser diode - (both not shown), the hot side of the thermoelectric cooler ($T_H$) and/or heat sink (not shown), and the Stirling cooler ($T_C$) (not shown) respectively.

In operation the system, via appropriate means, instructs the controller 11 to indicate whatever species are to be detected from the sample presently in the analytical measurement chamber 12. The controller then operates to adjust the temperature of the laser diode (not shown) by operating the thermoelectric cooler (not shown) and Stirling cooler (not shown). The Stirling cooler (not shown) provides large scale temperature adjustments, with smaller scale adjustments being made by the thermoelectric cooler (not shown). A thermal mount may be positioned between the thermoelectric cooler (not shown) and Stirling cooler (not shown). This enables very precise control of temperature, which in turn ensures very precise control of the output wavelength of the laser diode (not shown). Once light from the laser diode (not shown) has passed through the analytical measurement chamber 12 to the detecting component 13, data therefrom is provided to the analysing processor 14. The analysing processor 14 then provides an indication to the system, and via any suitable HMI 15 to the user or operator, of the presence and concentration or otherwise of the required species.

The controller 11 can be configured to adjust the temperature of the laser diode (not shown) over time such that the output wavelength of the diode (not shown) can be swept across a range of wavelengths to detect and quantify the concentration of multiple species within a particular wavelength range.

The controller may also be configured such that stepped temperature control is provided across a range of discrete temperatures, which in turn provides a range of stepped discrete wavelengths of output for the laser diode (not shown).

The use of a Stirling cooler (not shown) reduces the need for expensive cryogenic cooling structures and provides potential for the use of multiple light sources to cover increased wavelength ranges (and therefore increased numbers of detectable species) without introducing significant increases in analyser costs either for initial manufacture or on-going operation. Accordingly, the invention also provides an analyser of the type as described above with an array of light sources of the type shown in Figure 2 and configured to all illuminate a single analytical measurement chamber 12 or multiple analytical measurement chambers (not shown).

Furthermore, with two cooling components (one for fine tuning of the cooling and the other for larger cooling changes) in combination with a compensating thermal mass, it is possible to vary the temperature range of the light source quite significantly whilst still providing highly accurate levels of control to ensure accurate and reliable analysis.

**Claims**

1. A laser thermal tuning system for a tuneable diode laser spectroscopy device, the system comprising:

   a thermoelectric cooler;
   a further cooler controlled via open loop or closed loop control;
   a laser diode arranged between the thermoelectric cooler and the further cooler and coupled to each of the thermoelectric cooler and the further cooler; and
   control means for controlling each of the thermoelectric cooler and the further cooler to control the temperature of the laser diode and thereby vary the output wavelength of the laser diode.

2. A laser thermal tuning system according to claim 1, wherein the system further comprises a thermal mount.

3. A laser thermal tuning system according to claim 2, wherein the thermal mount is arranged to provide an interface from the laser diode to the further cooler.

4. A laser thermal tuning system according to claim 2 or 3, wherein the thermal mount is arranged to provide an interface from the laser diode to the external environment via the thermoelectric cooler.

5. A laser thermal tuning system according to any preceding claim, wherein the control means further controls the output of the laser diode to scan over a continuous range of wavelengths.

6. A laser thermal tuning system according to any preceding claim, wherein the control means further controls the output of the laser diode to provide scanning at discrete wavelength steps.

7. A laser thermal tuning system according to any preceding claim, wherein the further cooler is a Stirling cooler.

8. A spectroscopic analyser comprising a laser thermal tuning system according to any preceding claim, and further comprising:

   an analytical measurement chamber for receiving, in use, a sample to be analysed; and
   a light receiving component for receiving light from the system that has passed though the sample chamber to determine the nature of the sample.

10

2

3

4

FIG. 1

FIG. 2a

FIG. 2b

*40*

*20*

*11*

Laser thermal
tuning system

$T_H$ *8*

$T_D$ *7*

$T_C$ *9*

Controller

Analyzing processor ~ *14*

Analytical
measurement
chamber

Light receiving
component

HMI

*12*

*13*

*15*

## FIG. 3

Europäisches
Patentamt

European
Patent Office

Office européen
des brevets

# EUROPEAN SEARCH REPORT

Application Number

EP 15 18 4939

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 5 615 052 A (DOGGETT DAVID E [US]) 25 March 1997 (1997-03-25) | 1-6,8 | INV. H01S5/024 |
| A | * column 8, line 47 - column 11, line 34; figures 7,8 * * in particular column 10, line 51 - column 11, line 8 * | 7 | H01S5/06 G01N21/3504 G01N21/39 |
| X | WO 2009/116132 A1 (MITSUBISHI ELECTRIC CORP [JP]; NANBA CHISE [JP]; NAKAMURA AKIRA [JP];) 24 September 2009 (2009-09-24) * paragraphs [0014] - [0026]; figure 1 * | 1-8 | |
| X | JP 2007 088266 A (SONY CORP) 5 April 2007 (2007-04-05) * paragraphs [0054] - [0060]; figures 6A, 6B * | 1-4 | |
| X | JP 2002 353551 A (FUJI PHOTO FILM CO LTD) 6 December 2002 (2002-12-06) * abstract; figure 1 * | 1-6 | |
| A | JP 2011 119342 A (MIYACHI TECHNOS KK) 16 June 2011 (2011-06-16) * abstract; figure 3 * | 7 | TECHNICAL FIELDS SEARCHED (IPC) H01S G01N |
| A | JP 2006 277417 A (FUJITSU LTD) 12 October 2006 (2006-10-12) * abstract; figure 1 * | 1,7 | |
| E | EP 2 924 821 A1 (MICHELL INSTR LTD [GB]) 30 September 2015 (2015-09-30) * the whole document * | 1-8 | |
| E | -& GB 2 524 545 A (MICHELL INSTR LTD [GB]) 30 September 2015 (2015-09-30) * pages 1-11; claims 1-8; figures 1-3 * | 1-8 | |

The present search report has been drawn up for all claims

| Place of search | Date of completion of the search | Examiner |
|---|---|---|
| Munich | 25 February 2016 | Riechel, Stefan |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**

EP 15 18 4939

This annex lists the patent family members relating to the patent documents cited in the above-mentioned European search report.
The members are as contained in the European Patent Office EDP file on
The European Patent Office is in no way liable for these particulars which are merely given for the purpose of information.

25-02-2016

| Patent document cited in search report | | Publication date | Patent family member(s) | | Publication date |
|---|---|---|---|---|---|
| US 5615052 | A | 25-03-1997 | NONE | | |
| WO 2009116132 | A1 | 24-09-2009 | JP 5208200 B2 | | 12-06-2013 |
| | | | WO 2009116132 A1 | | 24-09-2009 |
| JP 2007088266 | A | 05-04-2007 | NONE | | |
| JP 2002353551 | A | 06-12-2002 | NONE | | |
| JP 2011119342 | A | 16-06-2011 | NONE | | |
| JP 2006277417 | A | 12-10-2006 | NONE | | |
| EP 2924821 | A1 | 30-09-2015 | EP 2924821 A1 | | 30-09-2015 |
| | | | GB 2524545 A | | 30-09-2015 |
| | | | US 2015280399 A1 | | 01-10-2015 |
| GB 2524545 | A | 30-09-2015 | EP 2924821 A1 | | 30-09-2015 |
| | | | GB 2524545 A | | 30-09-2015 |
| | | | US 2015280399 A1 | | 01-10-2015 |

EPO FORM P0459

For more details about this annex : see Official Journal of the European Patent Office, No. 12/82